# EUROPEAN PATENT SPECIFICATION

(11) **EP 4 411 833 B1**
(45) Date of publication and mention of the grant of the patent: **27.08.2025**
(21) Application number: 22957615.2
(22) Date of filing: 21.12.2022
(51) Int. Cl.: H10K 85/50, H10K 30/40, H10F 19/40, H10F 77/14, H10F 77/16, H10F 77/70, H10F 77/162, H10K 102/00

(54) **SOLAR CELL AND LAMINATED SOLAR CELL**
SOLARZELLE UND LAMINIERTE SOLARZELLE
CELLULE SOLAIRE ET CELLULE SOLAIRE STRATIFIÉE

(30) Priority: 13.12.2022 CN 202211618951
(43) Date of publication of application: 07.08.2024
(73) Proprietor: ZHEJIANG JINKO SOLAR CO., LTD., Haining, Zhejiang 314416 (CN); JINKO SOLAR CO., LTD., Shangrao, Jiangxi 334100 (CN)
(72) Inventor: ZHANG, Yuanfang, Haining, Zhejiang 314416 (CN); XU, Menglei, Haining, Zhejiang 314416 (CN); YANG, Jie, Haining, Zhejiang 314416 (CN); ZHANG, Xinyu, Haining, Zhejiang 314416 (CN)
(74) Representative: Balder IP Law, S.L.
(86) International application number: PCT/CN2022/140840
(87) International publication number: WO 2024/124610

(56) References cited:
- CN-A- 107 076 864
- CN-A- 109 545 973
- CN-A- 109 817 812
- CN-A- 111 816 773
- CN-B- 109 817 812
- KR-A- 20220 086 304
- US-A1- 2022 281 214
- XIONG LI ET AL: "Improved performance and stability of perovskite solar cells by crystal crosslinking with alkylphosphonic acid [omega]-ammonium chlorides", NATURE CHEMISTRY, vol. 7, no. 9, 17 August 2015 (2015-08-17), London, pages 703 - 711, XP055614944, ISSN: 1755-4330, DOI: 10.1038/nchem.2324
- FAN WENTAO ET AL: "NH3+-Functionalized PAMAM Dendrimers Enhancing Power Conversion Efficiency and Stability of Perovskite Solar Cells", JOURNAL OF ELECTRONIC MATERIALS, SPRINGER US, NEW YORK, vol. 50, no. 11, 3 September 2021 (2021-09-03), pages 6414 - 6425, XP037575728, ISSN: 0361-5235, [retrieved on 20210903], DOI: 10.1007/S11664-021-09169-Z

## Description

### TECHNICAL FIELD

Embodiments of the present application relate to the technical field of the solar cell, and in particular to a solar cell and a tandem solar cell.

### BACKGROUND

Fossil energy has atmospheric pollution and limited reserves, while solar energy has advantages such as cleanliness, pollution-free, and abundant resources. Therefore, solar energy is gradually becoming the core clean energy substitute for fossil energy. Due to its good photoelectric conversion efficiency, solar cells have become the focus of development for clean energy utilization.

An important factor affecting the proportion of solar energy in energy utilization is the photoelectric conversion efficiency of the solar cell. In order to improve the photoelectric conversion efficiency of the solar cell, optimizing and improving the structural design and material composition of the solar cell is a basic idea. Perovskite solar cells have good development prospects due to their long service life and relatively stable photoelectric conversion efficiency.

However, perovskite solar cells in the related technologies have limited photoelectric conversion ability and poor stability.

### SUMMARY

A solar cell and a tandem solar cell are provided according to the embodiments of the present application, which is at least conducive to preparing a large area perovskite solar cell with good photoelectric conversion efficiency and stability, thereby improving the photoelectric conversion ability of the perovskite solar cell.

A solar cell is provided according to the embodiments of the present application, and the solar cell includes a first conductive layer, a first carrier transport layer, a perovskite absorption layer, and a second conductive layer stacked along a first direction. The perovskite absorption layer includes a bonding matrix and multiple monocrystal perovskite particles arranged in the bonding matrix. The bonding matrix has a first side and a second side opposite to the first side. At least some of the multiple monocrystal perovskite particles has first convex surfaces and second convex surfaces, the first convex surfaces protrude out of the bonding matrix on the first side and the second convex surfaces protrude out of the bonding matrix on the second side.

In some embodiments, a distance between a respective monocrystal perovskite particle and an adjacent monocrystal perovskite particles in the multiple monocrystal perovskite particles is not greater than a maximum distance between any two points on a surface of the respective monocrystal perovskite particle.

In some embodiments, the maximum distance between any two points on the surface of the respective monocrystal perovskite particle is in a range of 5 µm to 100µm.

In some embodiments, an area of an orthographic projection of the perovskite absorption layer on the first conductive layer is a first area, an area of the orthographic projection of the multiple monocrystal perovskite particles on the first conductive layer is a second area, and a ratio of the second area to the first area is in a range of 0.3 to 0.9.

In some embodiments, a distance between any point on the first convex surface and a surface on the first side along the first direction is not greater than half of a maximum dimension of a single monocrystal perovskite particles along the first direction, and/or a distance between any point on the second convex surface and a surface on the second side is not greater than half of the maximum dimension of the single monocrystal perovskite particle along the first direction.

In some embodiments, a thickness of the bonding matrix is not less than 100 nm along the first direction.

In some embodiments, the bonding matrix includes a light trapping surface facing the first carrier transport layer and/or a light trapping surface facing the second conductive layer.

In some embodiments, the light trapping surface is provided with a first light trapping structure extending to outside of the bonding matrix along the first direction.

In some embodiments, the light trapping surface is provided with a second light trapping structure recessing into inside of the bonding matrix along the first direction.

In some embodiments, the first carrier transport layer is an electron transport layer or a hole transport layer.

In some embodiments, along the first direction, the thickness of the first carrier transport layer is in a range of 1nm-1µm.

In some embodiments, the solar cell also includes a second carrier transport layer, which is arranged between the perovskite absorption layer and the second conductive layer, and is in contact with the perovskite absorption layer and the second conductive layer, respectively.

In some embodiments, a thickness of the second carrier transport layer along the first direction is in a range of 1nm to 1µm.

In some embodiments, in response to the first carrier transport layer being a hole transport layer, the second carrier transport layer is an electron transport layer. In response to the first carrier transport layer being an electron transport layer, the second carrier transport layer is a hole transport layer.

Correspondingly, a tandem solar cell is further provided according to the embodiments of the present application, and the tandem solar cell includes a top cell, a bonding layer, and a bottom cell stacked in sequence, where the top cell is the solar cell provided according to the above embodiments.

In some embodiments, the bottom cell includes a crystalline silicon solar cell, a copper indium gallium selenide (CIGS) thin film solar cell, a cadmium telluride thin film solar cell, a III-V thin film solar cell, or a narrow bandgap perovskite thin film solar cell.

In some embodiments, the bonding layer includes a mechanical bonding layer formed by conductive adhesive.

The technical solution provided according to the embodiment of the present application has at least the following advantages.

In the formation process of the solar cell provided according to the embodiments of the present application, a bonding matrix and multiple monocrystal perovskite particles arranged in the bonding matrix are used to form the perovskite absorption layer of the solar cell. The multiple monocrystal perovskite particles are used to form a perovskite absorption layer, which ensures the stability of the perovskite absorption layer. The monocrystal perovskite particles are arranged in the bonding matrix, which avoids damage to the monocrystal perovskite caused by cutting process, thereby ensuring the efficiency of the solar cell. In addition, the arrangement of monocrystal particles is used to form a perovskite absorption layer for preparing the monocrystal perovskite solar cell with a large area. Among multiple monocrystal perovskite particles arranged in the bonding matrix, at least some of the monocrystal perovskite particles has a first convex surface protruding out of the first side of the bonding matrix and a second convex surface protruding out of the second side of the bonding matrix, respectively. The formation of a perovskite absorption layer is carried out by utilizing monocrystal perovskite particles exposed on both opposite sides of the bonding matrix, resulting in a textured structure of the perovskite absorption layer itself, which has good light absorption ability. Moreover, the ability of photo generated carriers to be transported from the perovskite absorption layer to the conductive layer or carrier transport layer is improved, and the photoelectric conversion efficiency and ability of the solar cell are improved.

CN109817812B or Xiong Li et al., NATURE CHEMISTRY, vol. 7, no. 9, pg. 703 - 711 (2015-08-17) show a solar cell featuring a perovskite absorption layer including a bonding matrix and a plurality of mono-crystal perovskite particles arranged in the bonding matrix.

### BRIEF DESCRIPTION OF THE DRAWINGS

One or more embodiments are described as examples with reference to the corresponding figures in the accompanying drawings, and the exemplary description does not constitute a limitation to the embodiments. The figures in the accompanying drawings do not constitute a proportion limitation unless otherwise stated.
FIG. 1 is a schematic structural view of a solar cell provided an embodiment of the present application;
FIG. 2 is a cross-sectional view of a solar cell provided according to an embodiment of the present application;
FIG. 3 is a top view of a perovskite absorption layer of a solar cell provided according to an embodiment of the present application;
FIG. 4 is a cross-sectional view of a perovskite absorption layer provided according to an embodiment of the present application;
FIG. 5 is a cross-sectional view of another solar cell provided according to an embodiment of the present application;
FIG. 6 is a cross-sectional view of yet another solar cell provided according to an embodiment of the present application;
FIG. 7 is a cross-sectional view of still another solar cell provided according to an embodiment of the present application;
FIG. 8 is a cross-sectional view of still another solar cell provided according to an embodiment of the present application;
FIG. 9 is a cross-sectional view of still another solar cell provided according to an embodiment of the present application;
FIG. 10 is a schematic structural view of another solar cell provided according to an embodiment of the present application; and
FIG. 11 is a schematic structural view of a tandem solar cell provided according to another embodiment of the present application.

### DETAILED DESCRIPTION

It can be seen from the background technology that the perovskite solar cell has good development prospects due to their advantages in service life and photoelectric conversion efficiency. However, the perovskite solar cell in related technologies has limited photoelectric conversion ability and poor stability.

A solar cell is provided according to some embodiments of the present application. A bonding matrix and multiple monocrystal perovskite particles arranged in the bonding matrix are used to form the perovskite absorption layer of the solar cell. The multiple monocrystal perovskite particles are used to form a perovskite absorption layer, which ensures the stability of the perovskite absorption layer. The monocrystal perovskite particles are arranged in the bonding matrix, which avoids damage to the monocrystal perovskite caused by cutting process, thereby ensuring the efficiency of the solar cell. In addition, the arrangement of monocrystal particles is used to form a perovskite absorption layer for preparing the monocrystal perovskite solar cell with a large area. Among multiple monocrystal perovskite particles arranged in the bonding matrix, at least some of the monocrystal perovskite particles has a first convex surface protruding out of the first side of the bonding matrix and a second convex surface protruding out of the second side of the bonding matrix, respectively. The formation of a perovskite absorption layer is carried out by utilizing monocrystal perovskite particles exposed on both opposite sides of the bonding matrix, resulting in a textured structure of the perovskite absorption layer itself, which has good light absorption ability. Moreover, the ability of photo generated carriers to be transported from the perovskite absorption layer to the conductive layer or carrier transport layer is improved, and the photoelectric conversion efficiency and ability of the solar cell are improved.

The embodiments of the present application will be described in detail below with reference to the accompanying drawings.

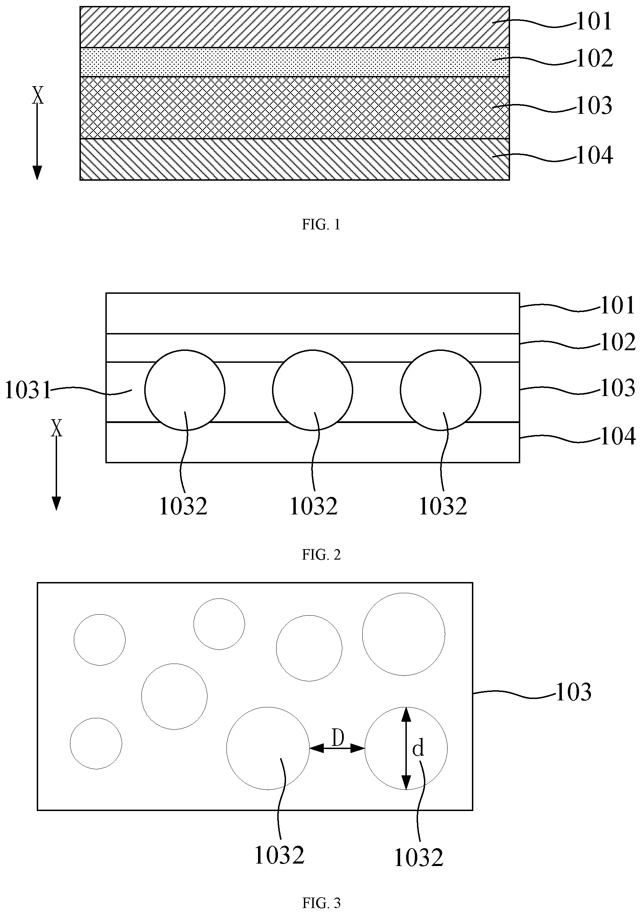

A solar cell is provided according to an embodiment of the present application, with reference to FIG. 1 to FIG. 3. Among them, FIG. 1 is a schematic structural view of a solar cell provided an embodiment of the present application. FIG. 2 is a cross-sectional view of a solar cell provided according to an embodiment of the present application. FIG. 3 is a top view of a perovskite absorption layer of a solar cell provided according to an embodiment of the present application.

The solar cell includes a first conductive layer 101, a first carrier transport layer 102, a perovskite absorption layer 103, and a second conductive layer 104 stacked along a first direction. The perovskite absorption layer 103 includes a bonding matrix 1031 and multiple monocrystal perovskite particles 1032 arranged in the bonding matrix 1031. Along the first direction, the bonding matrix 1031 includes a first side and a second side opposite to the first side. At least some of the multiple monocrystal perovskite particles 1032 has a first convex surface and a second convex surface. The first convex surface protrudes out of the bonding matrix 1031 on the first side and the second convex surface protrudes out of the bonding matrix 1031 on the second side.

The bonding matrix 1031 is configured to accommodate and fix monocrystal perovskite particles 1032 arranged in the bonding matrix 1031. Therefore, transparent curable adhesive or resin can be selected for formation, for example, ultraviolet curable adhesive such as acrylic adhesive or resin adhesive or other types of curable transparent adhesive can be selected for formation of the bonding matrix 1031. Among them, transparent refers to having good light transmittance for visible light, for example, having a transmittance of over 80% for light with wavelength above 400nm, or having a transmittance of over 75% for light with wavelength above 450nm.

The solar cell absorbs the light irradiating on the solar cell through the perovskite absorption layer 103, and then generates photo generated carriers through the multiple monocrystal perovskite particles 1032. Different photo generated carriers are collected through the first carrier transport layer 102 and the second conductive layer 104, respectively. Finally, the electricity generated by the solar cell is transmitted to external components through the first conductive layer 101 and the second conductive layer 104.

During the operation of the solar cell, the photoelectric conversion efficiency of the solar cell is mainly influenced by the ability to generate photogenerated carriers and the ability to collect and utilize photogenerated carriers. During the formation process of the perovskite absorption layer 103, a bonding matrix 1031 and multiple monocrystal perovskite particles 1032 arranged in the bonding matrix 1031 are used to complete the formation of the perovskite absorption layer 103, which ensures the integrity of the multiple monocrystal perovskite particles 1032, avoids damage to the monocrystal perovskite material during the formation process of the perovskite absorption layer 103, and ensures the ability of the perovskite absorption layer 103 to generate photo generated carriers.

In addition, monocrystal perovskite particles 1032 are used to form the perovskite absorption layer 103, which reduces the rate of decomposition of the perovskite absorption layer 103 during operation of the solar cell, thereby ensuring the stability of the perovskite absorption layer 103 and the solar cell. Moreover, monocrystal perovskite particles 1032 have a longer carrier life, higher carrier mobility, and longer diffusion degree. Therefore, the solar cell has a higher photoelectric conversion efficiency and a longer service life.

Moreover, the formation of the perovskite absorption layer 103 is carried out by arranging monocrystal perovskite particles 1032 in the bonding matrix 1031, which facilitates the simple and efficient preparation of a large area perovskite absorption layer 103, breaks through the constraints of the generation efficiency of monocrystal perovskite raw materials on the perovskite absorption layer 103 and the area of the perovskite solar cell, and greatly improves the preparation efficiency of stable large area perovskite solar cell, thereby improving the application prospects of the monocrystal perovskite solar cell.

Referring to FIG. 2, along the first direction, the bonding matrix 1031 includes a first side and a second side opposite the first side. At least some of the multiple monocrystal perovskite particles has a first convex surface and a second convex surface, the first convex surface protrudes out of the first side and the second convex surface protrudes out of the second side. In the process of forming the perovskite absorption layer 103, it is ensured that at least some monocrystal perovskite particles 1032 have a first convex surface and a second convex surface on the two opposite sides of the bonding matrix 1031, that is, at least some monocrystal perovskite particles 1032 will pass through the bonding matrix 1031 and come into contact with the first carrier transport layer 102 and the second conductive layer 104. Due to the fact that at least some monocrystal perovskite particles 1032 have a first convex surface and a second convex surface, the two opposite sides of the perovskite absorption layer 103 are textured, which enhances the light absorption ability of the perovskite absorption layer 103. In addition, due to at least some monocrystal perovskite particles 1032 passing through the bonding matrix 1031 and contacting the first carrier transport layer 102 and the second conductive layer 104, the difficulty of photo generated carriers moving to the first carrier transport layer 102 and the second conductive layer 104 is greatly reduced after the generation of photo generated carriers, which improves the photo generated carrier transport ability of the perovskite absorption layer 103. Furthermore, the photoelectric conversion efficiency of the perovskite absorption layer 103 has been improved in terms of light absorption capacity and carrier transport capacity.

It is worth mentioning that the shape of monocrystal perovskite particles 1032 can be regular polyhedron or irregular polyhedron, including spheres, near spheres, cubes, etc., and the size and shape of each monocrystal perovskite particle 1032 contained in the perovskite absorption layer 103 can be consistent or inconsistent, which will not be limited thereto the present application. For the convenience of understanding and explanation, the shape of monocrystal perovskite particles 1032 being sphere is taken as example in the present application embodiment for explanation. During actual application, the shape of monocrystal perovskite particles 1032 can be adjusted as needed, which is not limited thereto the embodiments of the present application.

In addition, the multiple monocrystal perovskite particles 1032 included in the perovskite absorption layer 103 can all have a first convex surface and a second convex surface, or some of the multiple monocrystal perovskite particles 1032 have a first convex surface and a second convex surface, and the other part of the multiple monocrystal perovskite particles 1032 only have a first convex surface, only have a second convex surface, or do not have a first convex surface and a second convex surface, which will not be limited thereto the embodiments of the present application.

In addition, each monocrystal perovskite particle 1032 in the perovskite absorption layer 103 is arranged into an ordered array in the bonding matrix 1031 at fixed intervals, for example, arranged into regular arrays of rectangular, nearly rectangular, circular, elliptical, and other shapes, which can further improve the uniformity of light absorption and carrier output in the perovskite absorption layer 103. It is also possible to freely arrange the multiple monocrystal perovskite particles 1032 in the bonding matrix 1031 in an unfixed interval and order, which will not be limited thereto the embodiments of the present application.

In some embodiments, for any monocrystal perovskite particle 1032, a distance between the current monocrystal perovskite particle 1032 and adj acent monocrystal perovskite particle 1032 is not greater than the maximum distance between any two points on the surface of the current monocrystal perovskite particle 1032.

Referring to FIG. 3, the two largest circles in the figure are circles formed horizontally through the centers of adjacent monocrystal perovskite particles 1032. The maximum distance between any two points on the surface of the current monocrystal perovskite particle is d, and the distance between the current monocrystal perovskite particle and adjacent monocrystal perovskite particles 1032 is D. D represents the minimum distance between any point on the surface of the current monocrystal perovskite particle and any point on the surface of adjacent monocrystal perovskite particle 1032. In response to the distance between adjacent monocrystal perovskite particles 1032 being too large, the perovskite absorption layer 103 has extremely poor light absorption ability in the area between adjacent monocrystal perovskite particles 1032, which leads to a decrease in the light absorption ability of the perovskite absorption layer 103 and affects the photoelectric conversion ability of the perovskite absorption layer 103.

However, the ability of monocrystal perovskite particles 1032 to absorb light gradually decreases as the distance between the light source and the multiple monocrystal perovskite particles 1032 increases. Therefore, it is necessary to limit the distance D between two adjacent monocrystal perovskite particles 1032 in the perovskite absorption layer 103, and the distance D between the current monocrystal perovskite particle 1032 and the adjacent monocrystal perovskite particles 1032 is set within a range smaller than the size of current monocrystal perovskite particle 1032. That is, D is set within the range of the maximum distance d between any two points on the surface of the current monocrystal perovskite particle, for example, D may be set to equal to 0.1d, 0.2d, 0.35d, 0.45d, 0.5d, 0.75d, or 0.9d. By setting the distance between the current monocrystal perovskite particle 1032 and the adjacent monocrystal perovskite particle 1032 within a range not larger than the size of the current monocrystal perovskite particle 1032, the perovskite absorption layer 103 has good absorption capacity for light, which avoids the problem of a decrease in light absorption capacity leading to a decrease in the photoelectric conversion efficiency of the solar cell.

In some embodiments, the distance between any point on the first convex surface and the first side along the first direction, and/or the distance between any point on the second convex surface and the second side, is not greater than half of the maximum dimension of the monocrystal perovskite particle 1032 along the first direction.

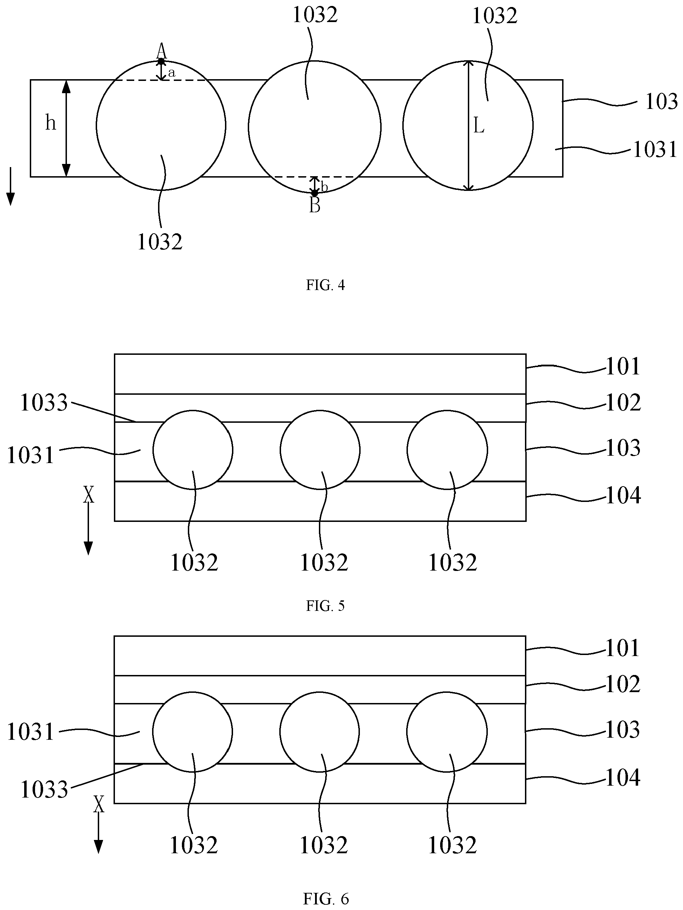

Referring to FIG. 2 and FIG. 4, FIG. 4 is a cross-sectional view of the perovskite absorption layer 103 formed vertically through the centers of three equally sized monocrystal perovskite particles 1032. In the perovskite absorption layer 103, the maximum distance between any point on the first convex surface of the monocrystal perovskite particle 1032 and the first side of the bonding matrix 1031 along the first direction is the distance a between a point A on the first convex surface that is farthest from the first side and the first side. Similarly, the maximum distance between any point on the second convex surface of monocrystal perovskite particle 1032 and the second side of the bonding matrix 1031 is the distance b between a point B on the second convex surface that is farthest from the second side and the second side b, and the maximum dimension of each of the multiple monocrystal perovskite particles 1032 is L.

In the process of forming the perovskite absorption layer 103, the bonding matrix 1031 is configured to fix the multiple monocrystal perovskite particles 1032. In order to ensure the fixation effect, the bonding matrix 1031 has a certain thickness. During the process of producing charge carriers in the multiple monocrystal perovskite particles 1032, different charge carriers converge and move towards both ends of the multiple monocrystal perovskite particles 1032. In response to the distance between point A on the first convex surface of monocrystal perovskite particles 1032 and the first side being greater than or equal to half of L, and/or in response to the distance between point B on the second convex surface and the second side being greater than or equal to half of L, the carriers collected on the first carrier transport layer 102 or the second conductive layer 104 may recombine with anisotropic carriers, resulting in a decrease in the photoelectric conversion efficiency of the perovskite absorption layer 103.

Therefore, in the process of forming a perovskite absorption layer 103, for monocrystal perovskite particles 1032 having a first convex surface and a second convex surface, along the first direction, the distance between any point on the first convex surface of monocrystal perovskite particles 1032 and the first side, and/or the distance between any point on the second convex surface and the second side, shall not be greater than half of the maximum dimension of monocrystal perovskite particles 1032 along the first direction. For example, the distance a and/or the distance b is set to be 0.1L, 0.15L, 0.2L, 0.25L, 0.35L, 0.45L, or 0.49L, etc. By limiting the distance between any point on the first convex surface of monocrystal perovskite particle 1032 and the first side, and/or the distance between any point on the second convex surface and the second side, the probability of recombination between anisotropic carriers is minimized to ensure the photoelectric conversion efficiency of the solar cell.

In some embodiments, the maximum distance between any two points on the surface of each of the multiple monocrystal perovskite particles 1032 is 5µm to 100µm.

In the process of forming the perovskite absorption layer 103, in response to the size of the selected monocrystal perovskite particle 1032 being too large, that is, in response to the maximum distance d between any two points on the particle surface being too large, the perovskite absorption layer 103 is formed through the monocrystal perovskite particle 1032. After absorbing light energy to generate carriers, the distance required for the carriers to migrate to the first carrier transport layer 102 or the second conductive layer 104 is too large, difficulty in completing carrier migration leads to a decrease in the photoelectric conversion efficiency of the solar cell. In response to the size of monocrystal perovskite particle 1032 being too small, that is, the maximum distance d between any two points on the particle surface is too small, the distance between different carriers during the migration process is very small. Therefore, carrier recombination is prone to occur, leading to a decrease in the photoelectric conversion efficiency of the solar cell. Moreover, in response to the size of the monocrystal perovskite particle 1032 being too small, the thickness of the perovskite absorption layer 103 is also very small. Under the influence of the potential difference on both sides, the probability of decomposition of the monocrystal perovskite particles 1032 is greatly increased, leading to a decrease in the stability of the solar cell.

Therefore, in the process of forming the perovskite absorption layer 103, monocrystal perovskite particles 1032 with a maximum distance of 5µm to 100µm between any two points on the particle surface are selected for formation. For example, monocrystal perovskite particles 1032 with the maximum distance of 5 µm, 7.5µm, 10µm, 15µm, 25µm, 60µm, 80µm, 85µm or 95µm between any two points on the particle surface are selected to form the perovskite absorption layer 103. While ensuring that the carriers in the perovskite absorption layer 103 can easily complete migration, the probability of recombination between different carriers and the probability of decomposition of monocrystal perovskite particles 1032 are reduced, thereby ensuring the photoelectric conversion efficiency and stability of the solar cell.

In some embodiments, an area of the orthographic projection of the perovskite absorption layer 103 on the first conductive layer 101 is the first area, and an area of the orthographic projection of multiple monocrystal perovskite particles 1032 on the first conductive layer 101 is the second area. The ratio of the second area to the first area is 0.3 to 0.9.

In the process of forming the perovskite absorption layer 103, the light absorption area of the perovskite absorption layer 103 during photoelectric conversion can be regarded as the sum of the orthogonal projection areas of all monocrystal perovskite particles 1032 on the first conductive layer 101, which is the second area. The area of the perovskite absorption layer 103 receiving light can be regarded as the orthographic projection area of the perovskite absorption layer 103 on the first conductive layer 101, which is the first area. In response to the ratio of the second area to the first area being too small, the absorption and utilization efficiency of the perovskite absorption layer 103 for light irradiated on the perovskite absorption layer 103 is very low, resulting in weak photoelectric conversion ability of the solar cell and difficulty in effectively conducting photoelectric conversion. Due to the limitation of the photoelectric conversion ability of the multiple monocrystal perovskite particles 1032, there is an upper limit to the absorption and utilization rate of light irradiated on the perovskite absorption layer 103 by the perovskite absorption layer 103. In response to the ratio of the second area to the first area being too large, there are monocrystal perovskite particles 1032 in the perovskite absorption layer 103 that are not fully utilized in terms of photoelectric conversion ability. The cost-effectiveness ratio between the manufacturing cost of the solar cell and the photoelectric conversion ability is relatively low.

Therefore, in the process of forming the perovskite absorption layer 103, it is necessary to limit the ratio of the area of the orthographic projection of each monocrystal perovskite particle 1032 in the perovskite absorption layer 103 on the first conductive layer 101 to the area of the orthographic projection of the perovskite absorption layer 103 on the first conductive layer 101. The ratio of the second area to the first area is set within the range of 0.3 to 0.9, such as 0.3, 0.35, 0.45, 0.5, 0.65, 0.7, 0.75, 0.8, or 0.85. By limiting the sum of the area of the orthographic projection of each monocrystal perovskite particle 1032 on the first conductive layer 101 to a certain range of the area of the orthographic projection of the perovskite absorption layer 103 on the first conductive layer 101, the absorption and utilization rate of light by the perovskite absorption layer 103 is ensured, while minimizing the preparation cost of the solar cell as much as possible.

In addition, in the process of forming the perovskite absorption layer 103, reference can also be made to the light transmission requirements of the top cell when forming a tandem solar cell using a perovskite solar cell as the top cell. Based on the type of bottom cell and the optimal photoelectric conversion efficiency of the tandem solar cell, the ratio of the required lighting area of the bottom cell to the area of the receiving surface of the bottom cell is determined when the tandem solar cell has the optimal or good photoelectric conversion efficiency. Based on the determined area ratio, the ratio of the second area to the first area in the perovskite absorption layer 103 is determined. For example, in response to the light receiving surface area of the bottom cell and the top cell being the same, and the bottom cell requires the top cell to transmit 30%, 50%, or 70% of the light to reach the bottom cell, so that the tandem solar cell has the optimal photoelectric conversion efficiency. Therefore, the ratio of the second area to the first area in the perovskite absorption layer 103 can be set to 0.7, 0.5, and 0.3 respectively.

In addition, monocrystal perovskite particles 1032 with a bandgap between 1eV and 2eV can be selected for the forming the perovskite solar cell to ensure the photoelectric conversion ability of the solar cell. In response to the perovskite cell being used as the top cell to form the tandem solar cell, the photoelectric conversion efficiency of the tandem solar cell is also related to the bandgap of monocrystal perovskite particles 1032 in the top cell. During the formation process of the tandem solar cell, monocrystal perovskite particles 1032 with bandgaps between 1.4eV and 1.8eV can be selected based on the type of bottom cell for forming the perovskite solar cell. In the process of selecting monocrystal perovskite particles 1032, it is sufficient to ensure that the tandem solar cell has good photoelectric conversion efficiency. The specific bandgap of the selected monocrystal perovskite particles 1032 is not limited in the embodiments of the present application.

Therefore, in the process of forming tandem solar cells, the ratio of the second area to the first area in the perovskite absorption layer 103 of the perovskite solar cell and the bandgap of the multiple monocrystal perovskite particles 1032 can be controlled separately to improve the photovoltaic conversion efficiency of the tandem solar cell as much as possible, based on the requirement of achieving good photovoltaic conversion efficiency.

It is worth mentioning that multiple monocrystal perovskite particles 1032 may contain monocrystal perovskite particles without a first convex surface and/or a second convex surface, while the photo generated carriers generated in the multiple monocrystal perovskite particles 1032 without a first convex surface and a second convex surface are difficult to complete carrier migration due to the limitations of the bonding matrix 1031. In order to further ensure the light utilization efficiency of the perovskite absorption layer 103, in the process of counting the second area, only the sum of the areas of the orthographic projection of each monocrystal perovskite particle 1032 containing the first convex surface and the second convex surface on the first conductive layer 101 can be counted. It is also possible to calculate the orthographic projection of all monocrystal perovskite particles 1032 with a first convex surface and/or a second convex surface on the first conductive layer 101, which will not be limited thereto the embodiments of the present application.

In some embodiments, the thickness of the bonding matrix 1031 is not less than 100 nm.

Referring to FIG. 2 and FIG. 4, the thickness h of the bonding matrix 1031 is represented by the distance between two opposite points along the first direction on the first side and the second side of the bonding matrix 1031. An important function of bonding matrix 1031 is to fix the multiple monocrystal perovskite particles 1032 that are accommodated and fixed in the bonding matrix 1031. Therefore, in response to the thickness h of bonding matrix 1031 along the first direction being too small, it is difficult to achieve stable fixation of monocrystal perovskite particles 1032, which may cause problems such as cracking, leading to a decrease in the stability of the solar cell. At the same time, it may also cause the distance between different carriers to be too small, leading to recombination between different carriers and a decrease in the photoelectric conversion efficiency of the solar cell.

Therefore, in the process of forming the bonding matrix 1031, it is necessary to ensure that the thickness h of bonding matrix 1031 along the first direction is not less than 100nm, for example, 100nm, 200nm, 350nm, 500nm, 800nm, 1µm, 5µm, 20 µm or 50µm, etc. By setting the thickness of the bonding matrix 1031 along the first direction sufficiently large, it is ensured that the bonding matrix 1031 can firmly fix the multiple monocrystal perovskite particles 1032, which avoids the failure of the perovskite absorption layer 103, improves the stability of the solar cell, and ensures that the distance between different carriers is large enough to avoid the recombination of different carriers, thereby ensuring the photoelectric conversion efficiency of the solar cell.

In addition, in response to the thickness h of the bonding matrix 1031 being too large along the first direction, the size of the multiple monocrystal perovskite particles 1032, i.e. the maximum distance between any two points on the particle surface, will also increase in order to have a first convex surface and a second convex surface, resulting in an increase in the migration difficulty of photo generated carriers generated by the monocrystal perovskite particle 1032, which in turn leads to a decrease in the photoelectric conversion efficiency of the solar cell.

Therefore, in the process of setting the bonding matrix 1031, it is not only necessary to consider the fixation effect and carrier isolation effect of the bonding matrix 1031 on the multiple monocrystal perovskite particles 1032, but also the influence of the bonding matrix 1031 on the photoelectric conversion ability of the selected monocrystal perovskite particles 1032. The thickness h of the bonding matrix 1031 along the first direction within is set within a range smaller than the size of the multiple monocrystal perovskite particles 1032 with good photoelectric conversion efficiency, thereby ensuring that the perovskite absorption layer 103 has the best possible photoelectric conversion efficiency.

Referring to FIG. 2, FIG. 5, and FIG. 7, in some embodiments, the bonding matrix 1031 includes a light trapping surface 1033 facing the first carrier transport layer 102 and/or the second conductive layer 104.

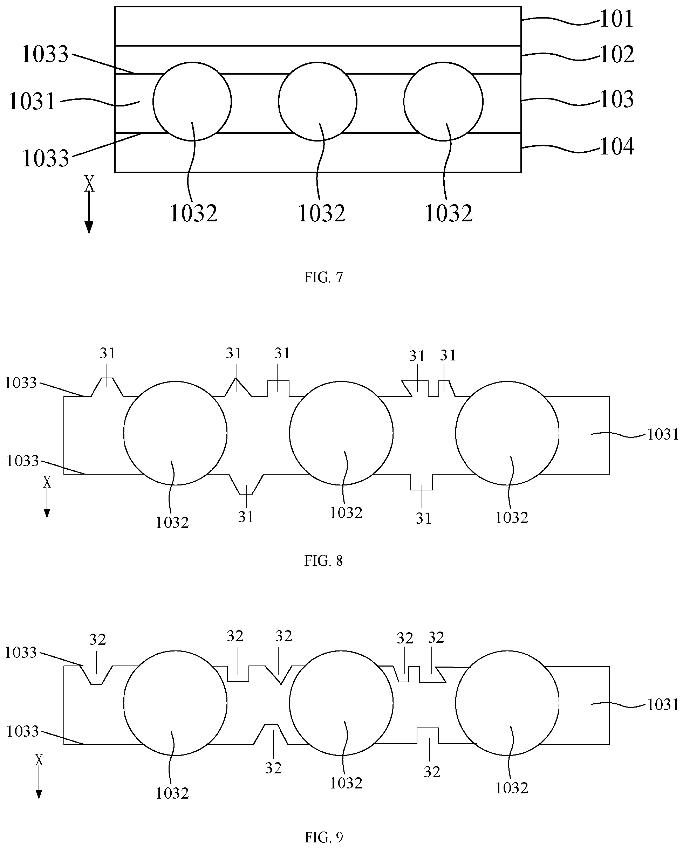

FIG. 5 to FIG. 7 are cross-sectional views of the solar cell in a vertical direction. The light trapping surface 1033 in FIG. 5 only includes a surface of the bonding matrix 1031 facing towards the first carrier transport layer 102, while the light trapping surface 1033 in FIG. 6 only includes a surface of the bonding matrix 1031 facing towards the second conductive layer 104. The light trapping surface 1033 in FIG. 7 includes a surface of the bonding matrix 1031 facing towards the first carrier transport layer 102 and a surface facing towards the second conductive layer 104. Another important function of the bonding matrix 1031 is to ensure the light absorption ability of the perovskite absorption layer 103. Therefore, during the production of the bonding matrix 1031, a light trapping surface 1033 can also be made on the bonding matrix 1031 to enhance the light absorption ability of the perovskite absorption layer 103. During the production process, the light trapping surface 1033 may only include the surface of the bonding matrix 1031 facing towards the first carrier transport layer 102, or, the light trapping surface 1033 may only include the surface of the bonding matrix 1031 facing towards the second conductive layer 104, or the light trapping surface 1033 may only include both the surface of the bonding matrix 1031 facing towards the first carrier transport layer 102 and the surface facing towards the second conductive layer 104.

By forming a light trapping surface 1033 facing towards the first carrier transport layer 102 and/or towards the second conductive layer 104 on the bonding matrix 1031, the optical path of the light shining on the perovskite absorption layer 103 is increased in the perovskite absorption layer 103, thereby improving the light absorption ability of the perovskite absorption layer 103 and improving the photoelectric conversion efficiency of the perovskite absorption layer 103 and the solar cell.

Referring to FIG. 2 and FIG. 8, in some embodiments, the light trapping surface 1033 includes a first light trapping structure 31 extending to outside of the bonding matrix 1031 along the first direction.

FIG. 8 shows a cross-sectional view of a solar cell with a light trapping surface 1033 that includes both a surface of the bonding matrix 1031 facing towards the first carrier transport layer and a surface facing towards the second conductive layer 104, and a light trapping surface 1033 that includes the first light trapping structure 31. During the process of forming a light trapping surface 1033 on the bonding matrix 1031, a first light trapping structure 31 is formed on the surface of the bonding matrix 1031 facing towards the first carrier transport layer 102 and/or facing towards the second conductive layer 104, that is, on the first side or the second side, one or more protrusions extending away from the bonding matrix 1031 is formed. The first light trapping structure 31 is arranged on the first side and/or the second side, and the positional relationship between any side of the first light trapping structure 31 and the first convex surface and/or second convex surface of each monocrystal perovskite particle 1032 in the perovskite absorption layer 103 is tangent or detached. The first light trapping structure 31 does not affect the contact area between the first convex surface and the first carrier transport layer 102, as well as the contact area between the second convex surface and the second conductive layer 104.

By forming one or more protrusions extending away from the bonding matrix 1031 on the first side or the second side as the first light trapping structure 31, the first side and/or the second side are changed to the light trapping surface 1033 with the ability to extend the optical path of incident light in the perovskite absorption layer 103, thereby improving the absorption and utilization ability of the perovskite absorption layer 103 to incident light. Furthermore, the photoelectric conversion ability and efficiency of the perovskite absorption layer 103 can be improved.

It is worth mentioning that the shape and size of each first light trapping structure 31 can be the same or different, which will not be limited thereto the embodiments of the present application.

Referring to FIG. 2 and FIG. 9, in some embodiments, the light trapping surface 1033 includes a second light trapping structure 32 recessing into the bonding matrix 1031 along the first direction.

FIG. 9 shows a cross-sectional view of a solar cell with a light trapping surface 1033 that includes both the surface of the bonding matrix 1031 facing towards the first carrier transport layer and a surface of the bonding matrix 1031 facing towards the second conductive layer 104, and a light trapping surface 1033 that includes a second light trapping structure 32. During the process of forming the light trapping surface 1033 on the bonding matrix 1031, a second light trapping structure 32 is formed on the surface of the bonding matrix 1031 facing towards the first carrier transport layer 102 and/or facing towards the second conductive layer 104, that is, one or more recesses recessing into the bonding matrix 1031 is formed on the first side or the second side. The second trapping structure 32 is arranged on the first side and/or the second side, and the positional relationship between any side of the second trapping structure 32 and the surface of each monocrystal perovskite particle 1032 arranged inside the bonding matrix 1031 in the perovskite absorption layer 103 is tangent or detached, and the second trapping structure 32 does not affect the contact area between the monocrystal perovskite particle 1032 and the bonding matrix 1031.

By forming one or more depressions extending towards the interior of the bonding matrix 1031 on the first side or the second side as the second trapping structure 32, the first and/or second side is changed to a trapping surface 1033 with the ability to extend the optical path of incident light in the perovskite absorption layer 103, thereby improving the absorption and utilization ability of the perovskite absorption layer 103 to incident light, and thereby improving the photoelectric conversion ability and efficiency of the perovskite absorption layer 103.

It is worth mentioning that the light trapping surface 1033 can only include one or more first light trapping structures 31, or only one or more second light trapping structures 32, and can also include both one or more first light trapping structures 31 and one or more second light trapping structures 32. The light trapping surface 1033 only includes the surface of the bonding matrix 1031 facing towards the first carrier transport layer 102, or only includes the surface of the bonding matrix 1031 facing towards the second conductive layer 104, or includes both the surface of the bonding matrix 1031 facing towards the first carrier transport layer 102 and the surface of the bonding matrix 1031 facing towards the second conductive layer 104. The embodiments of the present application do not limit the specific settings of the light trapping surface 1033, as well as the types and quantities of light trapping structures included on the light trapping surface 1033.

It is worth mentioning that the shape and size of each second trapping structure 32 can be the same or different, which will not be limited thereto the embodiments of the present application.

In some embodiments, the first carrier transport layer 102 is an electron transport layer or a hole transport layer.

The first carrier transport layer 102 is configured to collect and transport the carriers generated in the perovskite absorption layer 103. Based on the working mechanism of the solar cell, the first carrier transport layer 102 is a hole transport layer or an electron transport layer. In response to the first carrier transport layer 102 being an electron transport layer, the function of the first carrier transport layer 102 includes collecting electrons and transmitting the collected electrons to the first conductive layer 101 for electrical energy output, while also blocking the holes from flowing directly to the first conductive layer 101. In response to the first carrier transport layer 102 being a hole transport layer, the function of the first carrier transport layer 102 includes blocking electrons from entering the first conductive layer 101 and enhancing hole transport to prevent direct contact between the perovskite absorption layer 103 and the first conductive layer 101, thereby ensuring the photoelectric conversion ability and electrical energy output of the solar cell.

It is worth mentioning that the electron transport layer includes fullerene and its derivatives such as tin oxide SnOx, titanium dioxide TiO2, C₆₀, and [6,6]-phenyl-C61-butyric acid methyl ester (PCBM). The hole transport layer includes materials such as poly (bis (4-phenyl) (2,4,6-trimethylphenyl) amine) (PTAA), 2,2', 7,7'- tetrakis [N, N-di (4-methoxyphenyl) amino]-9,9 '-spirobifluorene (spiro-OMeTAD), nickel oxide (NiOx), or cuprous thiocyanide (CuSCN).

In some embodiments, the thickness of the first carrier transport layer 102 along the first direction is 1nm to 1µm.

The core function of the first carrier transport layer 102 is to improve the collection and transmission ability of one type of carrier, while isolating the contact between another type of carrier and the first conductive layer 101. Therefore, in response to the thickness of the first carrier transport layer 102 along the first direction being too large, the migration distance of carriers during transport to the first conductive layer 101 is too large, which may lead to carrier recombination, leading to significant carrier loss and a decrease in the photovoltaic conversion efficiency of the solar cell. In response to the thickness of the first carrier transport layer 102 along the first direction being too small, the ability of the first carrier transport layer 102 to collect and transport carriers is limited, and it may not be able to collect and transport all types of carriers generated by the perovskite absorption layer 103 in a timely manner, resulting in significant carrier loss and affecting the photovoltaic conversion efficiency of the solar cell. In addition, in response to the thickness being too small, there will also be a certain decrease in the isolation ability of another type of carrier, which may lead to the recombination of different types of carriers, thereby further affecting the photoelectric conversion efficiency of the solar cell.

Therefore, during the formation of the first carrier transport layer 102, the thickness of the first carrier transport layer 102 along the first direction is set at 1nm to 1µm. For example, 1nm, 5nm, 10nm, 50nm, 100nm, 200nm, 250nm, 400nm, 500nm, 650nm, 750nm, 800nm, or 950nm. The first carrier transport layer 102 is ensured to have sufficient aggregation and transmission capacity for one type of carrier, as well as sufficient isolation capacity for another type of carrier, which reduces carrier losses caused by carrier recombination and migration, thereby ensuring the photoelectric conversion efficiency of the solar cell.

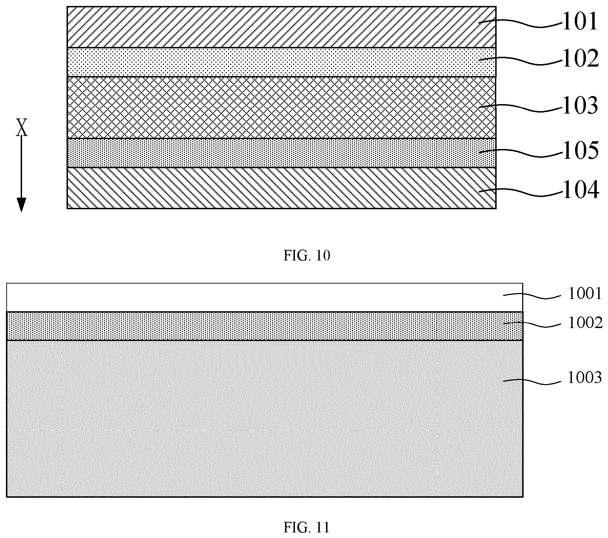

Referring to FIG. 10, in some embodiments, the solar cell further includes a second carrier transport layer 105, which is arranged between the perovskite absorption layer 103 and the second conductive layer 104 to be in contact with the perovskite absorption layer 103 and the second conductive layer 104, respectively.

The second carrier transport layer 105, similar to the first carrier transport layer 102, is configured to collect and transport a type of carrier generated in the perovskite absorption layer 103. Based on the working mechanism of the solar cell, the second carrier transport layer 105 is a hole transport layer or an electron transport layer. In response to the second carrier transport layer 105 being an electron transport layer, the function of the second carrier transport layer 105 includes collecting electrons and transmitting the collected electrons to the first conductive layer 101 for electrical energy output, while also blocking the holes from flowing directly to the first conductive layer 101. In response to the second carrier transport layer 105 being a hole transport layer, the function of the second carrier transport layer 105 includes blocking electrons from entering the first conductive layer 101 and enhancing hole transport to prevent direct contact between the perovskite absorption layer 103 and the first conductive layer 101, thereby ensuring the photoelectric conversion ability and electrical energy output of the solar cell.

In some embodiments, the thickness of the second carrier transport layer 105 along the first direction is 1nm to 1µm.

The core function of the second carrier transport layer 105 is to improve the collection and transmission ability of one type of carrier, while isolating the contact between another type of carrier and the first conductive layer 101. Therefore, in response to the thickness of the second carrier transport layer 105 along the first direction being too large, the migration distance of the carriers during transmission to the second conductive layer 104 is too large, which may lead to carrier recombination, leading to significant carrier loss and a decrease in the photovoltaic conversion efficiency of the solar cell. In response to the thickness of the second carrier transport layer 105 along the first direction being too small, the ability of the second carrier transport layer 105 to collect and transport carriers is limited, and it may not be able to collect and transport all carriers of a certain type generated by the perovskite absorption layer 103 in time, resulting in significant carrier loss and affecting the photoelectric conversion efficiency of the solar cell. In addition, in response to the thickness being too small, there will also be a certain decrease in the isolation ability of another type of carrier, which may lead to the recombination of different types of carriers, thereby further affecting the photoelectric conversion efficiency of the solar cell.

Therefore, during the formation of the second carrier transport layer 105, the thickness of the second carrier transport layer 105 along the first direction is 1nm to 1µm. For example, 1nm, 5nm, 10nm, 50nm, 100nm, 200nm, 250nm, 400nm, 500nm, 650nm, 750nm, 800nm, or 950nm. The second carrier transport layer 105 is ensured to have sufficient aggregation and transmission capacity for one type of carrier, as well as sufficient isolation capacity for another type of carrier, which reduces carrier losses caused by carrier recombination and migration, thereby ensuring the photovoltaic conversion efficiency of the solar cell.

In some embodiments, in response to the first carrier transport layer 102 being a hole transport layer, the second carrier transport layer 105 is an electron transport layer. In response to the first carrier transport layer 102 being an electron transport layer, the second carrier transport layer 105 is a hole transport layer.

In order to further improve the efficiency of the solar cell, carrier transport layers that collect and transport different carriers are arranged on both sides of the perovskite absorption layer 103 along the first direction, respectively, to improve the photoelectric conversion efficiency and stability of the solar cell as much as possible.

In summary, in the solar cell provided according to an embodiment of the present application, a bonding matrix 1031 and multiple monocrystal perovskite particles 1032 arranged in the bonding matrix 1031 are used to form the perovskite absorption layer 103 of the solar cell. The multiple monocrystal perovskite particles 1032 are used to form a perovskite absorption layer 103, which ensures the stability of the perovskite absorption layer 103. The monocrystal perovskite particles are arranged in the bonding matrix 1031, which avoids damage to the monocrystal perovskite caused by cutting process, thereby ensuring the efficiency of the solar cell. In addition, the arrangement of monocrystal particles is used to form a perovskite absorption layer 103 for preparing the monocrystal perovskite solar cell with a large area. Among multiple monocrystal perovskite particles 1032 arranged in the bonding matrix, at least some of the monocrystal perovskite particles 1032 has a first convex surface protruding out of the first side of the bonding matrix 1031 and a second convex surface protruding out of the second side of the bonding matrix 1031, respectively. The formation of the perovskite absorption layer 103 is carried out by utilizing monocrystal perovskite particles 1032 exposed on both opposite sides of the bonding matrix 1031, resulting in a textured structure of the perovskite absorption layer 103 itself, which has good light absorption ability. Moreover, the ability of photo generated carriers to be transported from the perovskite absorption layer 103 to the conductive layer or carrier transport layer is improved, and the photoelectric conversion efficiency and ability of the solar cell are improved.

Correspondingly, a tandem solar cell is further provided according to another embodiment of the present application. The schematic structural view of the tandem solar cell can refer to FIG. 11, the tandem solar cell includes a top cell 1001, a bonding layer 1002, and a bottom cell 1003 arranged in sequence, where the top cell 1001 is the solar cell according to above embodiments.

In some embodiments, the bottom cell 1003 includes a crystalline silicon solar cell, a CIGS thin film solar cell, a cadmium telluride thin film solar cell, a III-V thin film solar cell, or a narrow bandgap perovskite thin film solar cell. The narrow bandgap perovskite thin film solar cell is a narrow bandgap monocrystal perovskite thin film solar cell or a narrow bandgap polycrystalline perovskite thin film solar cell.

In some embodiments, the bonding layer 1002 includes a mechanical bonding layer including conductive adhesive. Among them, the conductive adhesive is formed by adding conductive particles to transparent adhesive with good light transmittance, for example, adding conductive particles to adhesive with a transmittance of over 80% for light with a wavelength above 400nm or 80% for light with a wavelength above 450nm. The conductive adhesive may also be a transparent thin adhesive containing particles with a certain amount of conductive energy. The degree of transparency can be similar to that of the above adhesive. The embodiments of the present application do not limit the specific types of conductive adhesives.

Those skilled in the art can understand that the above embodiments are specific embodiments to realize the present application. Therefore, the scope of protection of the present application shall be subject to the scope defined in the claims.

## Claims

1. A solar cell, comprising:
a first conductive layer (101), a first carrier transport layer (102), a perovskite absorption layer (103), and a second conductive layer (104) stacked along a first direction; and
the perovskite absorption layer (103) including a bonding matrix (1031) and a plurality of monocrystal perovskite particles (1032) arranged in the bonding matrix (1031), wherein the bonding matrix (1031) has a first side and a second side opposite to the first side;
wherein at least some of the plurality of monocrystal perovskite particles (1032) has respective first convex surfaces and respective second convex surfaces, **characterized in that**
the respective first convex surfaces protrude out of the bonding matrix (1031) on the first side and the respective second convex surfaces protrude out of the bonding matrix (1031) on the second side.

2. The solar cell according to claim 1, wherein a distance between a respective monocrystal perovskite particle and an adjacent monocrystal perovskite particles in the plurality of monocrystal perovskite particles (1032) is not greater than a maximum distance between any two points on a surface of the respective monocrystal perovskite particles.

3. The solar cell according to claim 2, wherein the maximum distance between any two points on the surface of the respective monocrystal perovskite particle (1032) is in a range of 5 µm to 100 µm.

4. The solar cell according to claim 1, wherein an area of an orthographic projection of the perovskite absorption layer (103) on the first conductive layer (101) is a first area, an area of an orthographic projection of the plurality of monocrystal perovskite particles (1032) on the first conductive layer (101) is a second area, and a ratio of the second area to the first area is in a range of 0.3 to 0.9.

5. The solar cell according to claim 1, wherein a distance between any point on the first convex surface and a surface on the first side along the first direction is not greater than half of a maximum dimension of a single monocrystal perovskite particle (1032) along the first direction, and/or a distance between any point on the second convex surface and a surface on the second side is not greater than half of the maximum dimension of the single monocrystal perovskite particles (1032) along the first direction.

6. The solar cell according to claim 1, wherein a thickness of the bonding matrix (1031) is not less than 100 nm along the first direction.

7. The solar cell according to claim 1, wherein the bonding matrix (1031) includes a light trapping surface (1033) facing the first carrier transport layer (102) and/or facing the second conductive layer (104).

8. The solar cell according to claim 7, wherein the light trapping surface (1033) is provided with a first light trapping structure (31) extending to outside of the bonding matrix (1031) along the first direction.

9. The solar cell according to claim 7, wherein the light trapping surface (1033) is provided with a second light trapping structure (32) recessed into inside of the bonding matrix (1031) along the first direction.

10. The solar cell according to claim 1, wherein the first carrier transport layer (102) is an electron transport layer or a hole transport layer; optionally, a thickness of the first carrier transport layer (102) along the first direction is in a range of 1nm to 1µm.

11. The solar cell according to claim 1, further comprising a second carrier transport layer (105) arranged between the perovskite absorption layer (103) and the second conductive layer (104), and the second carrier transport layer (105) is in contact with the perovskite absorption layer (103) and the second conductive layer (104) respectively.

12. The solar cell according to claim 11, wherein a thickness of the second carrier transport layer (105) along the first direction is in a range of 1nm to 1µm.

13. The solar cell according to claim 11, wherein in response to the first carrier transport layer (102) being a hole transport layer, the second carrier transport layer (105) is an electron transport layer;
in response to the first carrier transport layer (102) being an electron transport layer, the second carrier transport layer (105) is a hole transport layer.

14. A tandem solar cell, comprising a top cell (1001), a bonding layer (1002), and a bottom cell (1003) stacked in sequence, wherein the top cell is a solar cell according to any one of claims 1 to 13; optionally, the bonding layer includes a mechanical bonding layer formed by conductive adhesive.

15. The tandem solar cell according to claim 14, wherein the bottom cell (1002) includes a crystalline silicon solar cell, a copper indium gallium selenide (CIGS) thin film solar cell, a cadmium telluride thin film solar cell, a III-V thin film solar cell, or a narrow bandgap perovskite thin film solar cell.

## Patentansprüche

1. Solarzelle, umfassend:
eine erste leitfähige Schicht (101), eine erste Trägertransportschicht (102), eine Perowskit-Adsorptionsschicht (103) und eine zweite leitfähige Schicht (104), die entlang einer ersten Richtung gestapelt sind; und
wobei die Perowskit-Adsorptionsschicht (103) eine Bindungsmatrix (1031) und eine Vielzahl von monokristallinen Perowskit-Partikeln (1032) umfasst, die in der Bindungsmatrix (1031) angeordnet sind, wobei die Bindungsmatrix (1031) eine erste Seite und eine der ersten Seite entgegengesetzte zweite Seite aufweist;
wobei mindestens einige der Vielzahl von monokristallinen Perowskit-Partikeln (1032) jeweilige erste konvexe Oberflächen und jeweilige zweite konvexe Oberflächen aufweisen, **dadurch gekennzeichnet, dass** die jeweiligen ersten konvexen Oberflächen von der Bindungsmatrix (1031) auf der ersten Seite nach außen hervorstehen und die jeweiligen zweiten konvexen Oberflächen von der Bindungsmatrix (1031) auf der zweiten Seite nach außen hervorstehen.

2. Solarzelle nach Anspruch 1, wobei ein Abstand zwischen einem jeweiligen monokristallinen Perowskit-Partikel und einem benachbarten monokristallinen Perowskit-Partikel in der Vielzahl von monokristallinen Perowskit-Partikeln (1032) nicht größer ist als ein Höchstabstand zwischen beliebigen zwei Punkten auf einer Oberfläche der jeweiligen monokristallinen Perowskit-Partikel.

3. Solarzelle nach Anspruch 2, wobei der Höchstabstand zwischen beliebigen zwei Punkten auf der Oberfläche des jeweiligen monokristallinen Perowskit-Partikels (1032) im Bereich von 5 µm bis 100 µm liegt.

4. Solarzelle nach Anspruch 1, wobei eine Fläche einer orthographischen Projektion der Perowskit-Adsorptionsschicht (103) auf die erste leitfähige Schicht (101) eine erste Fläche ist, eine Fläche einer orthographischen Projektion der Vielzahl von monokristallinen Perowskit-Partikeln (1032) auf die erste leitfähige Schicht (101) eine zweite Fläche ist, und ein Verhältnis der zweiten Fläche zur ersten Fläche in einem Bereich von 0,3 bis 0,9 liegt.

5. Solarzelle nach Anspruch 1, wobei ein Abstand zwischen einem beliebigen Punkt auf der ersten konvexen Oberfläche und einer Oberfläche auf der ersten Seite entlang der ersten Richtung nicht größer als die Hälfte einer Höchstabmessung eines einzelnen monokristallinen Perowskit-Partikels (1032) entlang der ersten Richtung ist, und/oder ein Abstand zwischen einem beliebigen Punkt auf der zweiten konvexen Oberfläche und einer Oberfläche auf der zweiten Seite nicht größer als die Hälfte der Höchstabmessung der einzelnen monokristallinen Perowskit-Partikel (1032) entlang der ersten Richtung ist.

6. Solarzelle nach Anspruch 1, wobei eine Dicke der Bindungsmatrix (1031) entlang der ersten Richtung nicht weniger als 100 nm beträgt.

7. Solarzelle nach Anspruch 1, wobei die Bindungsmatrix (1031) eine Lichtfallenoberfläche (1033) umfasst, die der ersten Trägertransportschicht (102) zugewandt ist und/oder der zweiten leitfähigen Schicht (104) zugewandt ist.

8. Solarzelle nach Anspruch 7, wobei die Lichtfallenoberfläche (1033) mit einer ersten Lichtfallenstruktur (31) versehen ist, die sich zu einer Außenseite der Bindungsmatrix (1031) entlang der ersten Richtung erstreckt.

9. Solarzelle nach Anspruch 7, wobei die Lichtfallenoberfläche (1033) mit einer zweiten Lichtfallenstruktur (32) versehen ist, die in das Innere der Bindungsmatrix (1031) entlang der ersten Richtung vertieft ist.

10. Solarzelle nach Anspruch 1, wobei die erste Trägertransportschicht (102) eine Elektronentransportschicht oder eine Lochtransportschicht ist; wobei wahlweise eine Dicke der ersten Trägertransportschicht (102) entlang der ersten Richtung in einem Bereich von 1 nm bis 1 µm liegt.

11. Solarzelle nach Anspruch 1, ferner umfassend eine zweite Trägertransportschicht (105), die zwischen der Perowskit-Absorptionsschicht (103) und der zweiten leitfähigen Schicht (104) angeordnet ist, und die zweite Trägertransportschicht (105) mit der Perowskit-Absorptionsschicht (103) beziehungsweise der zweiten leitfähigen Schicht (104) in Kontakt ist.

12. Solarzelle nach Anspruch 11, wobei eine Dicke der zweiten Trägertransportschicht (105) entlang der ersten Richtung in einem Bereich von 1 nm bis 1 µm liegt.

13. Solarzelle nach Anspruch 11, wobei die zweite Trägertransportschicht (105) als Reaktion darauf, dass die erste Trägertransportschicht (102) eine Lochtransportschicht ist, eine Elektronentransportschicht ist;
die zweite Trägertransportschicht (105) als Reaktion darauf, dass die erste Trägertransportschicht (102) eine Elektronentransportschicht ist, eine Lochtransportschicht ist.

14. Tandem-Solarzelle, die eine obere Zelle (1001), eine Bindungsschicht (1002) und eine untere Zelle (1003) umfasst, die in Folge gestapelt sind, wobei die obere Zelle eine Solarzelle nach einem der Ansprüche 1 bis 13 ist; wobei die Bindungsschicht wahlweise eine mechanische Bindungsschicht ist, die aus leitfähigem Haftmittel gebildet ist.

15. Tandem-Solarzelle nach Anspruch 14, wobei die untere Zelle (1002) eine kristalline Siliziumsolarzelle, eine Kupfer-Indium-Gallium-Selenid(CIGS)-Dünnschicht-Solarzelle, eine Cadmiumtellurid-Dünnschicht-Solarzelle, eine III-V-Dünnschicht-Solarzelle oder eine Perowskit-Dünnschicht-Solarzelle mit schmalen Bandabstand umfasst.

## Revendications

1. Cellule solaire comprenant :
une première couche conductrice (101), une première couche de transport de porteurs (102), une couche d'absorption en perovskite (103), et une deuxième couche conductrice (104), empilées le long d'une première direction ; et
la couche d'absorption en perovskite (103) incluant une matrice de liaison (1031) et une pluralité de particules de perovskite monocristalline (1032) disposées dans la matrice de liaison (1031), dans laquelle la matrice de liaison (1031) a un premier côté et un deuxième côté opposé au premier côté ;
dans laquelle au moins certaines parmi la pluralité de particules de perovskite monocristalline (1032) ont des premières surfaces convexes respectives et des deuxièmes surfaces convexes respectives,
**caractérisée en ce que** les premières surfaces convexes respectives font saillie hors de la matrice de liaison (1031) sur le premier côté et les deuxièmes surfaces convexes respectives font saillie hors de la matrice de liaison (1031) sur le deuxième côté.

2. Cellule solaire selon la revendication 1, dans laquelle la distance entre une particule de perovskite monocristalline respective et une particule de perovskite monocristalline adjacente parmi la pluralité de particules de perovskite monocristalline (1032) n'est pas supérieure à la distance maximale entre deux points quelconques sur une surface des particules de perovskite monocristalline respectives.

3. Cellule solaire selon la revendication 2, dans laquelle la distance maximale entre deux points quelconques sur la surface de la particule de perovskite monocristalline respective (1032) est située dans la plage allant de 5 µm à 100 µm.

4. Cellule solaire selon la revendication 1, dans laquelle la superficie d'une projection orthographique de la couche d'absorption en perovskite (103) sur la première couche conductrice (101) est une première superficie, la superficie d'une projection orthographique de la pluralité de particules de perovskite monocristalline (1032) sur la première couche conductrice (101) est une deuxième superficie, et le rapport de la deuxième superficie à la première superficie est situé dans la plage allant de 0,3 à 0,9.

5. Cellule solaire selon la revendication 1, dans laquelle la distance entre un point quelconque sur la première surface convexe et une surface sur le premier côté le long de la première direction n'est pas supérieure à la moitié de la dimension maximale d'une particule de perovskite monocristalline isolée (1032) le long de la première direction, et/ou la distance entre un point quelconque sur la deuxième surface convexe et une surface sur le deuxième côté n'est pas supérieure à la moitié de la dimension maximale des particules de perovskite monocristallines isolées (1032) le long de la première direction.

6. Cellule solaire selon la revendication 1, dans laquelle l'épaisseur de la matrice de liaison (1031) n'est pas inférieure à 100 nm le long de la première direction.

7. Cellule solaire selon la revendication 1, dans laquelle la matrice de liaison (1031) inclut une surface piégeant la lumière (1033) faisant face à la première couche de transport de porteurs (102) et/ou faisant face à la deuxième couche conductrice (104).

8. Cellule solaire selon la revendication 7, dans laquelle la surface piégeant la lumière (1033) est dotée d'une première structure piégeant la lumière (31) s'étendant vers l'extérieur de la matrice de liaison (1031) le long de la première direction.

9. Cellule solaire selon la revendication 7, dans laquelle la surface piégeant la lumière (1033) est dotée d'une deuxième structure piégeant la lumière (32) creusée dans l'intérieur de la matrice de liaison (1031) le long de la première direction.

10. Cellule solaire selon la revendication 1, dans laquelle la première couche de transport de porteurs (102) est une couche de transport d'électrons ou une couche de transport de trous ; éventuellement l'épaisseur de la première couche de transport de porteurs (102) le long de la première direction est située dans la plage allant de 1 nm à 1 µm.

11. Cellule solaire selon la revendication 1, comprenant en outre une deuxième couche de transport de porteurs (105) disposée entre la couche d'absorption en perovskite (103) et la deuxième couche conductrice (104), et la deuxième couche de transport de porteurs (105) est en contact avec la couche d'absorption en perovskite (103) et la deuxième couche conductrice (104) respectivement.

12. Cellule solaire selon la revendication 11, dans laquelle l'épaisseur de la deuxième couche de transport de porteurs (105) le long de la première direction est située dans la plage allant de 1 nm à 1 µm.

13. Cellule solaire selon la revendication 11, dans laquelle, en réponse au fait que la première couche de transport de porteurs (102) est une couche de transport de trous, la deuxième couche de transport de porteurs (105) est une couche de transport d'électrons ;
en réponse au fait que la première couche de transport de porteurs (102) est une couche de transport d'électrons, la deuxième couche de transport de porteurs (105) est une couche de transport de trous.

14. Cellule solaire tandem, comprenant une cellule supérieure (1001), une couche de liaison (1002), et une cellule inférieure (1003) empilées en séquence, dans laquelle la cellule supérieure est une cellule solaire selon l'une quelconque des revendications 1 à 13 ; éventuellement la couche de liaison inclut une couche de liaison mécanique formée par un adhésif conducteur.

15. Cellule solaire tandem selon la revendication 14, dans laquelle la cellule inférieure (1002) inclut une cellule solaire en silicium cristallin, une cellule solaire à couche mince en séléniure de cuivre, indium et gallium (CIGS), une cellule solaire à couche mince en tellurure de cadmium, une cellule solaire à couche mince III-V, ou une cellule solaire à couche mince en perovskite à bande interdite étroite.
